# EUROPEAN PATENT SPECIFICATION

(11) **EP 2 249 494 B1**
(45) Date of publication and mention of the grant of the patent: **31.07.2013**
(21) Application number: 10161977.3
(22) Date of filing: 05.05.2010
(51) Int. Cl.: H04B 17/00, G01R 27/06

(54) **Standing wave detection method, standing wave detection device, and base station**
Stehwellendetektionsverfahren, Stehwellendetektionsvorrichtung und Basisstation
Procédé de détection d'onde stationnaire, dispositif de détection d'onde stationnaire et station de base

(30) Priority: 07.05.2009 CN 200910050984
(43) Date of publication of application: 10.11.2010
(73) Proprietor: Huawei Technologies Co., Ltd., Shenzhen, Guangdong 518129 (CN)
(72) Inventor: Wang, Tuoxin, 518129, Shenzhen Guangdong (CN)
(74) Representative: Isarpatent

(56) References cited:
- EP-A2- 0 844 485
- WO-A1-2005/069664
- US-B1- 6 313 644

## Description

### FIELD OF THE TECHNOLOGY

The present invention relates to the field of mobile communication technology, and more particularly to a standing wave detection method, a standing wave detection device, and a base station.

### BACKGROUND OF THE INVENTION

In the field of wireless communication, the standing wave alarm detection technology is one of the key technologies of a base station system. The aim of the standing wave alarm detection technology is to detect the performance of a base station antenna feed system on a base station radio air interface and a connection status of the base station antenna feed system to a base station. During standing wave detection, a standing wave ratio is obtained by detecting amplitudes of forward and reverse signals at a base station antenna port and performing certain operations. When the standing wave ratio exceeds a preset threshold, an alarm is sent and corresponding measures are taken.

In order to detect the standing wave ratio, a standing wave detection device is provided in the prior art. The standing wave detection device mainly includes a directional coupler, a circulator, logarithmic detectors, a reflected power sampler, a transmit power load, and a comparison amplifier. The standing wave detection method includes the following steps. When radio frequency (RF) power signals are input to the circulator and then output to the directional coupler, part of the output signals are extracted through the directional coupler and transfer to one logarithmic detector for forward power detection. Meanwhile, due to standing wave reflection, part of the RF power signals are reflected back, and the reflected signals first pass through a transmitting end of the circulator and then pass through the reflected power sampler before being absorbed by a reflected power load of the circulator. After passing through the reflected power sampler, part of the reflected power is sampled and transfer to another logarithmic detector for reflected power detection. The values obtained through the forward and reverse power detection are output to the comparison amplifier and then a standing wave detection signal is output after comparison amplification operations.

Although the prior art can realize collection of a forward power and a reverse power for standing wave detection, and obtain a standing wave ratio, the prior art introduces a dedicated detection circuit and uses many components when acquiring a forward power value and a reverse power value, which increases the product costs.

In US 6313644B1, a technical solution for measuring a voltage standing wave ratio of a base station is provided, which comprises: a unit for measuring the voltage standing wave ratio of a transmitting terminal by coupling an input signal from the base station, and by comparing the difference of the coupled signal and a signal reflected from a transmitting antenna; and another unit for measuring the voltage standing wave ratio of a receiving terminal by comparing an input signal from a base-station test unit with the signal reflected from a receiving terminal.

### SUMMARY OF THE INVENTION

In order to solve the problem that the standing wave detection device in the prior art has a high cost, the present invention is directed to a standing wave detection method, a standing wave detection device, and a base station capable of collecting forward power signals and reverse power signals without using a dedicated detection circuit.

In an embodiment, the present invention provides a standing wave detection method, which includes: acquiring a forward digital domain power value L1 of a forward transmission channel and a gain value L2 of a variable gain circuit of the forward transmission channel, and a reverse power value L3 of a sampled reverse power signal in a same time slot, wherein the sampled reverse power signal is sampled from reverse power signals by a reverse coupler; and obtaining a standing wave ratio according to the L1, the L2, and the L3; wherein the obtaining the standing wave ratio according to the L1, L2, and L3 includes: obtaining a forward power value L4 according to the L1 and the L2, and obtaining the standing wave ratio according to the L4 and the L3.

In an embodiment, the present invention further provides a standing wave detection device, which includes a first acquisition unit, a second acquisition unit, a third acquisition unit, a standing wave calculation unit. The first acquisition unit is adapted to acquire a forward digital domain power value L1 of a forward transmission channel. The second acquisition unit is adapted to acquire a gain value L2 of a variable gain circuit of the forward transmission channel in a same time slot as the forward digital domain power value L1. The third acquisition unit is adapted to acquire a reverse power value L3 of a sampled reverse power signal, wherein the sampled reverse power signal is sampled from reverse power signals by a reverse coupler. The standing wave calculation unit, adapted to obtain a standing wave ratio according to the L1, the L2, and the L3, wherein the standing wave ratio is obtained according to the L3 and a forward power value L4 which is obtained based on the L1 and L2, wherein the L1, the L2, and the L3 is acquired in a same time slot.

In an embodiment, the present invention further provides a base station, which includes the above-mentioned standing wave detection device.

In the standing wave detection method provided in the embodiment of the present invention, a forward digital domain power value L1 of a forward transmission channel and a gain value L2 of a variable gain circuit are detected, and a forward power value is obtained by using a relationship between the digital domain power value and the gain value of the variable gain circuit in the forward transmission channel of a base station system, instead of using a separate logarithmic detector for detecting the forward power value. As compared with the prior art, the standing wave detection method provided in the embodiments of the present invention not only can realize collection of a forward power and a reverse power for standing wave detection, and obtain a standing wave ratio, but also can make use of circuits in the prior art without adding a separate standing wave detection circuit when detecting the forward power value and the reverse power value, and thus the production costs can be saved.

### BRIEF DESCRIPTION OF THE DRAWINGS

FIG. 1 is a schematic diagram of a closed-loop power control circuit applying an embodiment of a method according to the present invention;
FIG. 2 is a flow chart of an embodiment of a standing wave detection method according to the present invention;
FIG. 3 is a schematic diagram of an embodiment of a standing wave detection device according to the present invention;
FIG. 4 is a schematic diagram of a third acquisition unit in the embodiment of the standing wave detection device according to the present invention;
FIG. 5 is a schematic diagram of a feedback processing module in the embodiment of the standing wave detection device according to the present invention; and
FIG. 6 is a schematic diagram of an embodiment of a base station according to the present invention.

### DETAILED DESCRIPTION OF THE EMBODIMENTS

Embodiments of present invention provide a standing wave detection method, a standing wave detection device for implementing the method, and a base station. For better understanding of the technical solution of the present invention, the embodiments provided in the present invention are described in detail below with reference to the accompanying drawings.

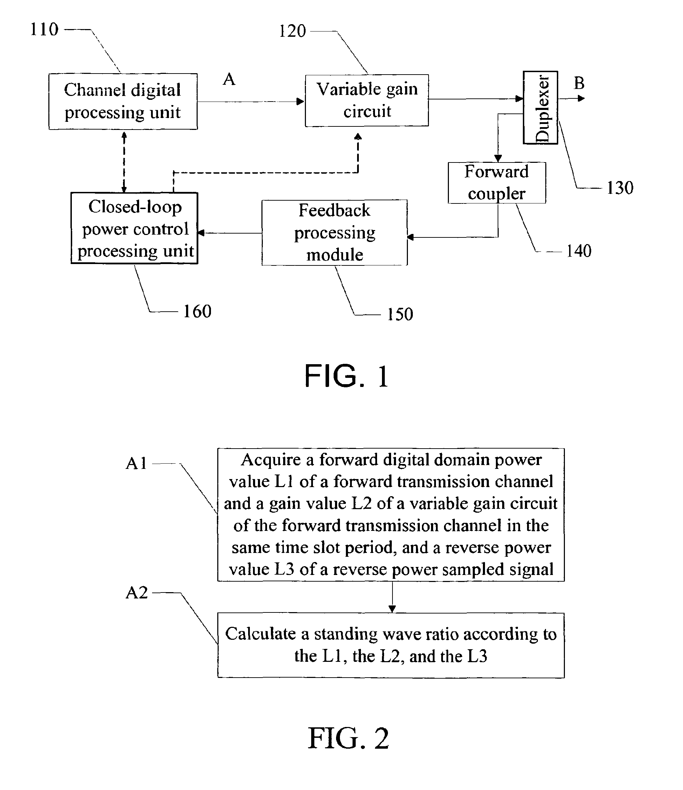

In an existing base station system, to make an output power of a base station meet configuration requirements, a closed-loop gain control method is generally employed, i.e. the base station system requirements are met by coupling the output power of an end of the base station and controlling the output power of the base station. FIG. 1 is a schematic diagram of a closed-loop power control circuit applying an embodiment of a method according to the present invention.

The closed-loop power control circuit mainly includes a closed-loop power control processing unit 160, a feedback processing module 150, and a forward coupler 140.

When the base station works, the gain consistency of a variable gain circuit 120 in an analog circuit of a transmission channel is poor, i.e. different samples have different gains and the gain value of the same sample varies nonlinearly with temperature and frequency An input end of the forward coupler 140 is coupled to a forward output end of a duplexer 130. The forward coupler 140 is adapted to sample forward power signals and output a sampled forward power signal. The feedback processing module 150 processes the sampled forward power signal, and then outputs a sampled forward power signal in a digital domain. An input end of the closed-loop power control processing unit 160 is connected to an output end of the feedback processing module 150. The closed-loop power control processing unit 160 adjusts a gain value generated by the variable gain circuit 120 according to a digital domain power (i.e. the power at point A in FIG. 1) of a forward transmission channel output by a channel digital processing unit 110 and the sampled forward power signal in the digital domain, thereby ensuring that a total output power (i.e. the power at point B in FIG. 1) of the base station meets the system configuration requirements. During the practical work of the base station system, if the feedback processing module 150 detects that the sampled forward power signal is less than a predetermined value, a gain value of the variable gain circuit 120 is increased, so that the output power of the base station system will reach the predetermined value.

FIG. 2 is a flow chart of an embodiment of a standing wave detection method according to the present invention.

In step A1, a forward digital domain power value L1 of a forward transmission channel, a gain value L2 of a variable gain circuit of the forward transmission channel, and a reverse power value L3 of a sampled reverse power signal in a same time slot are acquired.

In a same time slot, the forward digital domain power value L1 of a forward transmission channel, the gain value L2 of the variable gain circuit 120 of the forward transmission channel, and the reverse power value L3 of a sampled reverse power signal are acquired.

In the embodiment of the present invention, the sampled reverse power signal is digitized by the feedback processing module 150 in the closed-loop power control circuit, and the reverse power value L3 is then acquired by detecting a sampled reverse power signal in the digital domain, Furthermore, the method for acquiring the reverse power value L3 of the reverse power signal is not thus limited, and other methods may also be used.

In step A2: a standing wave ratio is obtained according to the L1, L2, and L3.

In the embodiment of the present invention, a forward power value L4 may be obtained according to the acquired forward digital domain power value L1 and gain value L2 of the variable gain circuit 120. Then the standing wave ratio may be obtained according to the forward power value L4 and the reverse power value L3.

As compared with the prior art, the embodiment of the standing wave detection method in the present invention can acquire a forward power value L4 and a reverse power value L3 in a same time slot by using existing circuits in the base station system when collecting the forward power value and the reverse power value without adding a separate detection circuit, thereby the production costs can be saved.

When the standing wave ratio is obtained, the embodiment of the standing wave detection method in the present invention may detect multiple sets of L1, L2, and L3, and may obtain mean values of the multiple L1, L2 and L3 separately. Thus the precision of standing wave detection can be increased.

The embodiment of the standing wave detection method in the present invention may further include the following step between steps A1 and A2.

It is determined whether the acquired L1, L2, and L3 are valid according to basic parameters of the base station system. If it is determined that the L1, L2, L3 are all valid, the step of obtaining the standing wave ratio according to the L1, L2, and L3 is triggered. If it is determined that any of the L1, L2, and L3 is invalid, the current standing wave detection process is stopped, and the step of acquiring the forward digital domain power value L1 of the forward transmission channel, the gain value L2 of the variable gain circuit 120 of the forward transmission channel, and the reverse power value L3 of the sampled reverse power signal in a same time slot is performed again.

The reasonableness determination of the acquired L1, L2, and L3 is added in the embodiment of the standing wave detection method in the present invention, and thus the precision of standing wave detection can be increased.

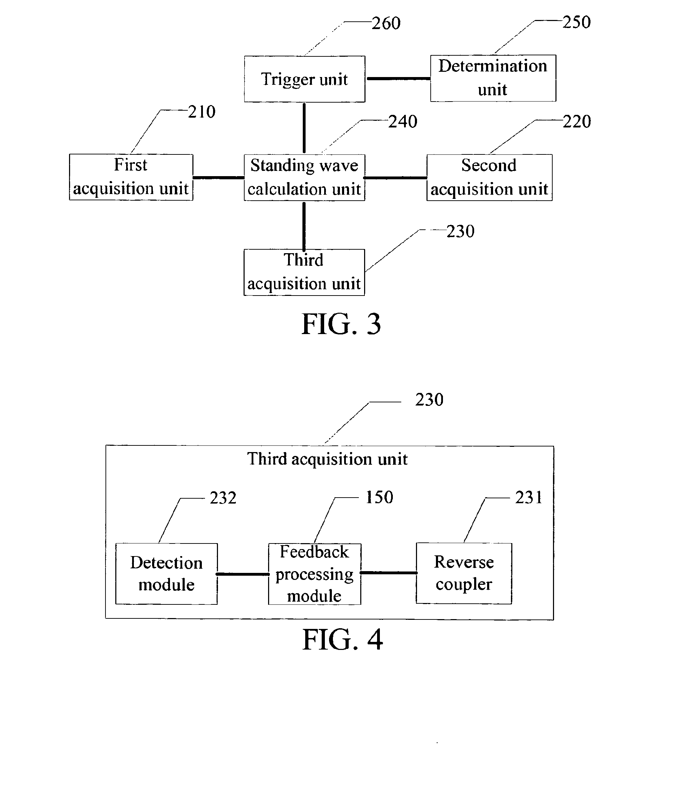

FIG. 3 is a schematic diagram of an embodiment of a standing wave detection device according to the present invention.

The standing wave detection device mainly includes a first acquisition unit 210, a second acquisition unit 220, a third acquisition unit 230, and a standing wave calculation unit 240.

The first acquisition unit 210 is adapted to acquire a forward digital domain power value L1 of a forward transmission channel.

The second acquisition unit 220 is adapted to acquire a gain value L2 of a variable gain circuit 120 of the forward transmission channel.

The third acquisition unit 230 is adapted to acquire a reverse power value L3 of a sampled reverse power signal.

The standing wave calculation unit 240 is adapted to obtain a standing wave ratio according to the L1, L2, and L3.

The embodiment of the standing wave detection device in the present invention may further include a determination unit 250 and a trigger unit 260.

The determination unit 250 is adapted to determine the validity of the L1 acquired by the first acquisition unit 210, the L2 acquired by the second acquisition unit 220, and the L3 acquired by the third acquisition unit 230. Because the L1, L2, and L3 are parameters related to specific base station systems, they have certain reasonable ranges respectively. The trigger unit 260 triggers the standing wave calculation unit 240 to obtain the standing wave ratio according to the L1, L2, and L3 if the determination unit 250 determines that the L1, L2, and L3 are all valid.

The reasonableness determination of the acquired L1, L2, and L3 is added in the embodiment of the standing wave detection device in the present invention, and thus the detection precision of the standing wave detection device can be increased.

The standing wave calculation unit 240 obtains the standing wave ratio according to mean values of multiple L1, L2 and L3 separately.

FIG. 4 is a schematic diagram of the third acquisition unit in the embodiment of the standing wave detection device according to the present invention.

The third acquisition unit 230 may include: a reverse coupler 231, the feedback processing module 150, and a detection module 232. The reverse coupler 231 has an input end coupled to a reverse output end of a duplexer and an output end coupled to an input end of the feedback processing module 150. The reverse coupler 231 is adapted to sample reverse power signals and output a sampled reverse power signal.

The feedback processing module 150 is adapted to convert the sampled reverse power signal output by the reverse coupler 231 into a sampled reverse power signal in a digital domain and output the sampled reverse power signal in the digital domain.

The detection module 232 is adapted to detect the reverse power value L3 of the sampled reverse power signal in the digital domain output by the feedback processing module 150.

In the embodiment of the standing wave detection device in the present invention, the reverse coupler 231 acquires the sampled reverse power signal, then the feedback processing module 150 converts the sampled reverse power signal into a sampled reverse power signal in the digital domain, and the detection module 232 detects a power value of the sampled reverse power signal in the digital domain that is output by the feedback processing module 150 to obtain the reverse power value L3. The prior art requires the use of logarithmic detectors in acquisition of both a forward power value and a reverse power value. However, the embodiment of the present invention uses the feedback processing module 150 and the detection module 232 to acquire the reverse power value L3 without using any logarithmic detector, and the feedback processing module 150 exists in an existing closed-loop power control circuit. The embodiment of the present invention further acquires a forward power value according to a power relationship of the closed-loop power control circuit. Therefore, the embodiment of the standing wave detection device in the present invention uses an existing closed-loop circuit for standing wave detection without using a dedicated detection circuit, and thus the cost of the standing wave detection device can be reduced.

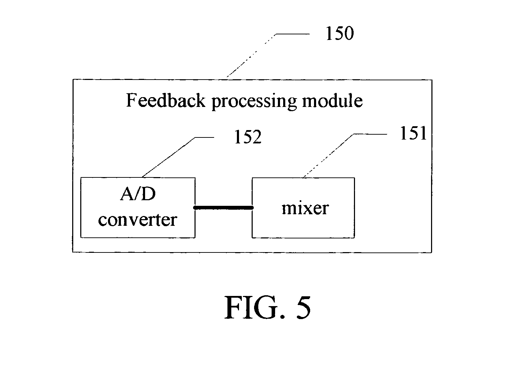

FIG. 5 is a schematic diagram of the feedback processing module in the embodiment of the standing wave detection device according to the present invention.

Feedback processing module 150 may further include a mixer 151 and an analog-to-digital (A/D) converter 152. The mixer 151 is adapted to perform frequency-convert processing to the sampled reverse power signal output by the reverse coupler 231, and then the processed signal is output by the mixer 151. The A/D converter 152 is adapted to convert the output signal of the mixer 151 into the sampled reverse power signal in the digital domain, and the output signal of mixer 151 is a frequency-converted sampled reverse power signal. Furthermore, as compared with the prior art in which power detection is performed by a logarithmic detector, the embodiment of the standing wave detection device in the present invention uses the A/D converter having high precision and good stability when detecting the reverse power value, thereby the detection precision and temperature stability of the standing wave detection device can be increased.

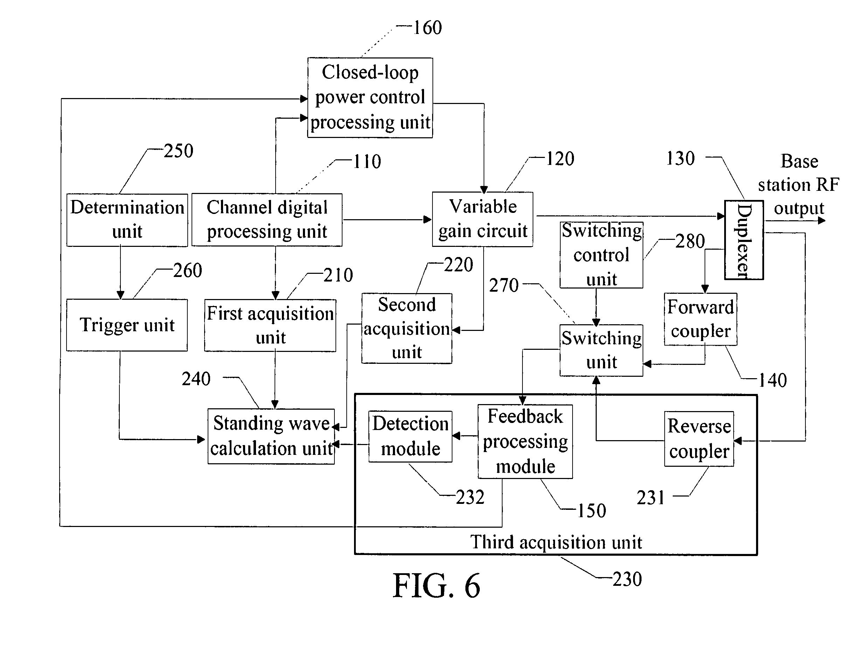

FIG. 6 is a schematic diagram of an embodiment of a base station according to the present invention.

The embodiment of the base station provided in the present invention mainly includes: the first acquisition unit 210, the second acquisition unit 220 , the third acquisition unit 230, and the standing wave calculation unit 240. The first acquisition unit 210 is adapted to acquire the forward digital domain power value L1 of a forward transmission channel. The second acquisition unit 220 is adapted to acquire a gain value L2 of a variable gain circuit of the forward transmission channel. The third acquisition unit 230 is adapted to acquire the reverse power value L3 of a sampled reverse power signal. The standing wave calculation unit 240 is adapted to obtain the standing wave ratio according to the L1, L2, and L3.

The embodiment of the base station provided in the present invention may further include the determination unit 250 and the trigger unit 260.

The determination unit 250 is adapted to determine whether the L1, L2, and L3 are valid.

The trigger unit 260 is adapted to trigger the standing wave calculation unit 240 to obtain the standing wave ratio according to the L1, L2, and L3 if the determination unit 250 determines that the L1, L2, and L3 are all valid.

The third acquisition unit 230 in the embodiment of the base station in the present invention may include the reverse coupler 231, the feedback processing module 150, and the detection module 232.

The reverse coupler 231 has an input end coupled to a reverse output end of a duplexer and an output end coupled to an input end of the feedback processing module 150. The reverse coupler 231 is adapted to sample reverse power signals and output a sampled reverse power signal.

The feedback processing module 150 is adapted to convert the sampled reverse power signal output by the reverse coupler 231 into a sampled reverse power signal in a digital domain and output the sampled reverse power signal in the digital domain.

The detection module 232 is adapted to detect the reverse power value L3 of the sampled reverse power signal in the digital domain output by the feedback processing module 150.

The embodiment of the base station in the present invention may further include a forward coupler 140, a switching unit 270, a switching control unit 280, and the closed-loop power control processing unit 160.

The forward coupler 140 has an input end coupled to a forward output end of the duplexer and an output end coupled to the input end of the feedback processing module 150. The forward coupler 140 is adapted to sample forward power signals and output a sampled forward power signal. The feedback processing module 150 is further adapted to convert the sampled forward power signal output by the forward coupler 140 into a sampled forward power signal in the digital domain and output the sampled forward power signal in the digital domain.

The switching unit 270 is adapted to switch an input signal of the feedback processing module 150 between the sampled forward power signal and the sampled reverse power signal.

The switching control unit 280 is adapted to control the switching operation of the switching unit 270.

The closed-loop power control processing unit 160 has an input end connected to an output end of the feedback processing module 150 and an output end connected to the variable gain circuit of the forward transmission channel. The closed-loop power control processing unit 160 is adapted to adjust a gain value of the variable gain circuit 120 of the forward transmission channel according to the input sampled forward power signal after the switching unit 270 switches the input signal of the feedback processing module 150 to the sampled forward power signal.

In the embodiment of the present invention, the base station may perform time division multiplexing on the closed-loop power control circuit. When the switching unit 270 switches the input signal of the feedback processing module 150 to the sampled forward power signal, i.e. the input end of the feedback processing module 150 is connected to the output end of the forward coupler 140, the closed-loop power control circuit is adapted to control an output power of the base station, adjust a gain value of the variable gain circuit 120, and ensure a stable power of a forward transmit power signal of the base station. When the switching unit 270 switches the input signal of the feedback processing module 150 to the sampled reverse power signal, i.e., the input end of the feedback processing module 150 is connected to the output end of the reverse coupler 231, the closed-loop power control circuit performs standing wave detection. Therefore, the embodiment of the base station in the present invention can realize both the closed-loop power control function and the standing wave detection function. The standing wave detection function and the closed-loop power control function are applied in time division multiplexing, so that part of the hardware circuit can be shared, and thus the production cost of the base station can be saved.

In the embodiment of the present invention, the feedback processing module may further include a mixer 151 and an A/D converter 152. The mixer 151 is adapted to perform frequency-convert processing to the sampled reverse power signal output by the reverse coupler 231 when the input signal of the feedback processing module 150 is switched to the sampled reverse power signal. The mixer 151 is adapted to perform frequency-convert processing the sampled forward power signal output by the reverse coupler 140 when the input signal of the feedback processing module 150 is switched to the sampled forward power signal. Then the processed signal of the mixer 151 is output by the mixer 151. Accordingly, the A/D converter 152 is adapted to convert the sampled reverse power signal frequency-converted and output by the mixer 151 into the sampled reverse power signal in the digital domain, or convert the sampled forward power signal frequency-converted and output by the mixer 151 into the sampled forward power signal in the digital domain. As compared with the prior art in which power detection is performed by a logarithmic detector, the embodiment of the base station in the present invention uses the A/D converter having high precision and good stability when detecting the reverse power value, thereby the detection precision and temperature stability of standing wave detection can be increased.

The switching unit 270 may be a single pole double throw switch or other components having the input signal selection function. The standing wave calculation unit 240 and the closed-loop power control processing unit 160 are applied in time division multiplexing, so that the production cost can also be saved.

Through the descriptions of the preceding embodiments, those skilled in the art may understand that the present invention may be implemented by hardware only or by software and a necessary universal hardware platform. Based on such understandings, the technical solution under the present invention may be embodied in the form of a software product. The software product may be stored in a nonvolatile storage medium, which can be a Compact Disk Read-Only Memory (CD-ROM), USB flash drive, or a removable hard drive. The software product includes a number of instructions that enable a computer device (personal computer, server, or network device) to execute the methods provided in the embodiments of the present invention.

The standing wave detection method, the standing wave detection device, and the base station provided in the embodiments of the present invention are described in detail above. Persons of ordinary skill in the art can make variations and modifications to the present invention in terms of the specific implementations and application scopes according to the present invention. Therefore, the specification shall not be construed as a limitation to the present invention.

## Claims

1. A standing wave detection method, comprising:
acquiring (A1), in a same time slot ,a forward digital domain power value L1 of a forward transmission channel and a gain value L2 of a variable gain circuit of the forward transmission channel, and a reverse power value L3 of a sampled reverse power signal, wherein the sampled reverse power signal is sampled from reverse power signals by a reverse coupler (231); and
obtaining (A2) a standing wave ratio according to the L1, L2, and L3;
wherein the obtaining the standing wave ratio according to the L1, L2, and L3 comprises:
obtaining a forward power value L4 according to the L1 and the L2, and
obtaining the standing wave ratio according to the L4 and the L3.

2. The standing wave detection method according to claim 1, wherein acquiring the L3 comprises:
digitizing a sampled reverse power signal by a feedback processing module in a closed-loop power control circuit;
acquiring the L3 by detecting a sampled reverse power signal in a digital domain.

3. The standing wave detection method according to any one of claims 1-2, further comprising:
determining that the L1, the L2, and the L3 are all valid before obtaining the standing wave ratio.

4. The standing wave detection method according to any one of claims 1-3, wherein obtaining the standing wave ratio comprises:
obtaining mean values of multiple L1, L2, and L3 separately;
obtaining the standing wave ratio according to the mean values of the multiple L1, L2, and L3.

5. A standing wave detection device, comprising:
a first acquisition unit(210), adapted to acquire a forward digital domain power value L1 of a forward transmission channel;
a second acquisition unit(220), adapted to acquire a gain value L2 of a variable gain circuit of the forward transmission channel;
a third acquisition unit(230), adapted to acquire a reverse power value L3 of a sampled reverse power signal, wherein the sampled reverse power signal is sampled from reverse power signals by a reverse coupler (231); and
a standing wave calculation unit(240), adapted to obtain a standing wave ratio according to the L1, the L2, and the L3, wherein the standing wave ratio is obtained according to the L3 and a forward power value L4 which is obtained based on the L1 and L2, wherein the L1, the L2, and the L3 is acquired in a same time slot.

6. The standing wave detection device according to claim 5, further comprising:
a determination unit(250), adapted to determine whether the L1, the L2, and the L3 are valid; and
a trigger unit(260), adapted to trigger the standing wave calculation unit(240) to obtain the standing wave ratio according to the L1, the L2, and the L3 if the determination unit determines that the L1, the L2, and the L3 are all valid.

7. The standing wave detection device according to claim 5 or 6 wherein the third acquisition unit comprises:
said reverse coupler(231), coupling at an input end to a reverse output end of a duplexer and at an output end to an input end of a feedback processing module(150), and adapted to sample reverse power signals and output a sampled reverse power signal;
the feedback processing module(150), adapted to convert the sampled reverse power signal output by the reverse coupler(231) into a sampled reverse power signal in a digital domain and output the sampled reverse power signal in the digital domain; and
a detection module(232), adapted to detect the reverse power value L3 of the sampled reverse power signal in the digital domain output by the feedback processing module(150).

8. The standing wave detection device according to claim 7, wherein the feedback processing module comprises:
a mixer(151), adapted to perform frequency-convert processing to the sampled reverse power signal output by the reverse coupler(231), and output the processed signal; and
an analog-to-digital, A/D, converter(152), adapted to convert the sampled reverse power signal frequency-converted and output by the mixer(151) into the sampled reverse power signal in the digital domain.

9. The standing wave detection device according to any one of claims 5-8, wherein the standing wave calculation unit (240) obtains the standing wave ratio according to mean values of multiple L1, L2, and L3 .

10. A base station, comprising a standing wave detection device according to any one of claims 5-9.

11. The base station according to claim 10, further comprising:
a switching unit(270), adapted to switch an input signal of the feedback processing module(150) between the sampled forward power signal and the sampled reverse power signal;
a switching control unit(280), adapted to control the switching operation of the switching unit(270).

12. The base station according to claim 11, further comprising:
a forward coupler(140), adapted to sample forward power signals and output a sampled forward power signal, wherein the forward coupler(140) has an input end coupled to a forward output end of the duplexer(130) and an output end coupled to the input end of the feedback processing module(150), and the feedback processing module(150) is further adapted to convert the sampled forward power signal output by the forward coupler(140) into a sampled forward power signal in the digital domain and output the sampled forward power signal in the digital domain; and
a closed-loop power control processing unit(160), adapted to adjust a gain value of the variable gain circuit of the forward transmission channel according to the input sampled forward power signal in the digital domain after the switching unit switches the input signal of the feedback processing module(150) to the sampled forward power signal.

13. The base station according to claim 11 or 12, wherein:
the mixer(151) is further adapted to perform frequency-convert processing on the sampled forward power signal output by the reverse coupler(231), ; and
the A/D converter(152) is further adapted to convert the sampled forward power signal frequency-converted and output by the mixer into the sampled forward power signal in the digital domain.

## Patentansprüche

1. Stehwellen-Detektionsverfahren, umfassend:
Beschaffen (A1) eines Vorwärts-Digitaldomänen-Leistungswerts L1 eines Vorwärts-Übertragungskanals und eines Verstärkungswerts L2 einer variablen Verstärkungsschaltung des Vorwärts-Übertragungskanals und eines Rückwärts-Leistungswerts L3 eines abgetasteten Rückwärts-Leistungssignals in einem selben Zeitschlitz, wobei das abgetastete Rückwärts-Leistungssignal durch einen Rückwärts-Koppler (231) aus Rückwärts-Leistungssignalen abgetastet wird; und
Erhalten (A2) eines Stehwellenverhältnisses gemäß L1, L2 und L3;
wobei das Erhalten des Stehwellenverhältnisses gemäß L1, L2 und L3 Folgendes umfasst:
Erhalten eines Vorwärts-Leistungswerts L4 gemäß L1 und L2 und
Erhalten des Stehwellenverhältnisses gemäß L4 und L3.

2. Stehwellen-Detektionsverfahren nach Anspruch 1, wobei das Beschaffen von L3 Folgendes umfasst:
Digitalisieren eines abgetasteten Rückwärts-Leistungssignals durch ein Rückkopplungsverarbeitungsmodul in einer Leistungsregelschaltung mit geschlossener Schleife;
Beschaffen von L3 durch Detektieren eines abgetasteten Rückwärts-Leistungssignals in einer Digitaldomäne.

3. Stehwellen-Detektionsverfahren nach einem der Ansprüche 1-2, ferner umfassend:
Bestimmen, dass L1, L2 und L3 alle gültig sind, bevor das Stehwellenverhältnis erhalten wird.

4. Stehwellen-Detektionsverfahren nach einem der Ansprüche 1-3, wobei das Erhalten des Stehwellenverhältnisses Folgendes umfasst:
Erhalten von Mittelwerten mehrerer L1, L2 und L3 separat;
Erhalten des Stehwellenverhältnisses gemäß den Mittelwerten der mehreren L1, L2 und L3.

5. Stehwellen-Detektionsvorrichtung, umfassend:
eine erste Beschaffungseinheit (210), die dafür ausgelegt ist, einen Vorwärts-Digitaldomänen-Leistungswert L1 eines Vorwärts-Übertragungskanals zu beschaffen;
eine zweite Beschaffungseinheit (220), die dafür ausgelegt ist, einen Verstärkungswert L2 einer variablen Verstärkungsschaltung des Vorwärts-Übertragungskanals zu beschaffen;
eine dritte Beschaffungseinheit (230), die dafür ausgelegt ist, einen Rückwärts-Leistungswert L3 eines abgetasteten Rückwärts-Leistungssignals zu beschaffen,
wobei das abgetastete Rückwärts-Leistungssignal durch einen Rückwärts-Koppler (231) aus Rückwärts-Leistungssignalen abgetastet wird, und
eine Stehwellen-Berechnungseinheit (240), die dafür ausgelegt ist, ein Stehwellenverhältnis gemäß L1, L2 und L3 zu erhalten, wobei das Stehwellenverhältnis gemäß L3 und einem Vorwärts-Leistungswert L4, der auf der Basis von L1 und L2 erhalten wird, erhalten wird, wobei L1, L2 und L3 in einem selben Zeitschlitz beschafft werden.

6. Stehwellen-Detektionsvorrichtung nach Anspruch 5, ferner umfassend:
eine Bestimmungseinheit (250), die dafür ausgelegt ist, zu bestimmen, ob L1, L2 und L3 gültig sind; und
eine Triggereinheit (260), die dafür ausgelegt ist, die Stehwellen-Berechnungseinheit (240) zu trigger, das Stehwellenverhältnis gemäß L1, L2 und L3 zu erhalten, wenn die Bestimmungseinheit bestimmt, dass L1, L2 und L3 alle gültig sind.

7. Stehwellen-Detektionsvorrichtung nach Anspruch 5 oder 6, wobei die dritte Beschaffungseinheit Folgendes umfasst:
den Rückwärts-Koppler (231), der ein Eingangsende mit einem Rückwärts-Ausgangsende eines Duplexers und ein Ausgangsende mit einem Eingangsende eines Rückkopplungsverarbeitungsmoduls (150) koppelt und dafür ausgelegt ist,
Rückwärts-Leistungssignale abzutasten und ein abgetastetes Rückwärts-Leistungssignal auszugeben;
das Rückkopplungsverarbeitungsmodul (150), das dafür ausgelegt ist, das von dem Rückwärts-Koppler (231) ausgegebene abgetastete Rückwärts-Leistungssignal in ein abgetastetes Rückwärts-Leistungssignal in einer Digitaldomäne umzusetzen und das abgetastete Rückwärts-Leistungssignal in der Digitaldomäne auszugeben; und
ein Detektionsmodul (232), das dafür ausgelegt ist, den von dem Rückkopplungsverarbeitungsmodul (150) ausgegebenen Rückwärts-Leistungswert L3 des abgetasteten Rückwärts-Leistungssignals in der Digitaldomäne zu detektieren.

8. Stehwellen-Detektionsvorrichtung nach Anspruch 7, wobei das Rückkopplungsverarbeitungsmodul Folgendes umfasst:
einen Mischer (151), der dafür ausgelegt ist, Frequenzumsetzungsverarbeitung an dem durch den Rückwärts-Koppler (231) ausgegebenen abgetasteten Rückwärts-Leistungssignal auszuführen und das verarbeitete Signal auszugeben, und
einen Analog-Digital- bzw. A/D-Umsetzer (152), der dafür ausgelegt ist, das durch den Mischer (151) frequenzumgesetzte und ausgegebene abgetastete Rückwärts-Leistungssignal in das abgetastete Rückwärts-Leistungssignal in der Digitaldomäne umzusetzen.

9. Stehwellen-Detektionsvorrichtung nach einem der Ansprüche 5-8, wobei die Stehwellen-Berechnungseinheit (240) das Stehwellenverhältnis gemäß Mittelwerten mehrerer L1, L2 und L3 erhält.

10. Basisstation, die eine Stehwellen-Detektionsvorrichtung nach einem der Ansprüche 5-9 umfasst.

11. Basisstation nach Anspruch 10, ferner umfassend:
eine Schalteinheit (270), die dafür ausgelegt ist, ein Eingangssignal des Rückkopplungsverarbeitungsmoduls (150) zwischen dem abgetasteten Vorwärts-Leistungssignal und dem abgetasteten Rückwärts-Leistungssignal umzuschalten;
eine Schaltsteuereinheit (280), die dafür ausgelegt ist, die Schaltoperation der Schalteinheit (270) zu steuern.

12. Basisstation nach Anspruch 11, ferner umfassend:
einen Vorwärts-Koppler (140), der dafür ausgelegt ist, Vorwärts-Leistungssignale abzutasten und ein abgetastetes Vorwärts-Leistungssignal auszugeben, wobei der Vorwärts-Koppler (140) ein mit einem Vorwärts-Ausgangsende des Duplexers (130) gekoppeltes Eingangsende und ein mit dem Eingangsende des Rückkopplungsverarbeitungsmoduls (150) gekoppeltes Ausgangsende aufweist und das Rückkopplungsverarbeitungsmodul (150) ferner dafür ausgelegt ist, das durch den Vorwärts-Koppler (140) ausgegebene abgetastete Vorwärts-Leistungssignal in ein abgetastetes Vorwärts-Leistungssignal in der Digitaldomäne umzusetzen und das abgetastete Vorwärts-Leistungssignal in der Digitaldomäne auszugeben; und
eine Leistungsregelungs-Verarbeitungseinheit (160) mit geschlossener Schleife, die dafür ausgelegt ist, einen Verstärkungswert der variablen Verstärkungsschaltung des Vorwärts-Übertragungskanals gemäß dem eingegebenen abgetasteten Vorwärts-Leistungssignal in der Digitaldomäne zu justieren, nachdem die Schalteinheit das Eingangssignal des Rückkopplungsverarbeitungsmoduls (150) auf das abgetastete Vorwärts-Leistungssignal umschaltet.

13. Basisstation nach Anspruch 11 oder 12, wobei
der Mischer (151) ferner dafür ausgelegt ist, Frequenzumsetzungsverarbeitung an dem durch den Rückwärts-Koppler (231) ausgegebenen abgetasteten Vorwärts-Leistungssignal auszuführen; und
der A/D-Umsetzer (152) ferner dafür ausgelegt ist, das durch den Mischer frequenzumgesetzte und ausgegebene abgetastete Vorwärts-Leistungssignal in das abgetastete Vorwärts-Leistungssignal in der Digitaldomäne umzusetzen.

## Revendications

1. Procédé de détection d'ondes stationnaires, comprenant :
l'acquisition (A1), dans une même tranche de temps, d'une valeur de puissance aller L1 dans le domaine numérique d'un canal de transmission aller et d'une valeur de gain L2 d'un circuit de gain variable du canal de transmission aller, et d'une valeur de puissance retour L3 d'un signal de puissance retour échantillonné, le signal de puissance retour échantillonné étant échantillonné à partir de signaux de puissance retour par un coupleur retour (231) ; et
l'obtention (A2) d'un rapport d'ondes stationnaires en fonction de L1, L2 et L3 ;
dans lequel l'obtention du rapport d'ondes stationnaires en fonction de L1, L2 et L3 comprend :
l'obtention d'une valeur de puissance aller L4 en fonction de L1 et de L2, et
l'obtention du rapport d'ondes stationnaires en fonction de L4 et de L3.

2. Procédé de détection d'ondes stationnaires selon la revendication 1, dans lequel l'acquisition de L3 comprend :
la numérisation d'un signal de puissance retour échantillonné par un module de traitement de rétroaction dans un circuit de commande de puissance à boucle fermée ;
l'acquisition de L3 en détectant un signal de puissance retour échantillonné dans un domaine numérique.

3. Procédé de détection d'ondes stationnaires selon l'une quelconque des revendications 1 et 2, comprenant en outre :
la détermination que L1, L2 et L3 sont toutes valables avant l'obtention du rapport d'ondes stationnaires.

4. Procédé de détection d'ondes stationnaires selon l'une quelconque des revendications 1 à 3, dans lequel l'obtention du rapport d'ondes stationnaires comprend :
l'obtention de valeurs moyennes de multiples L1 , L2 et L3 séparément ;
l'obtention du rapport d'ondes stationnaires en fonction des valeurs moyennes des multiples L1, L2 et L3.

5. Dispositif de détection d'ondes stationnaires, comprenant :
un première unité d'acquisition (210), adaptée pour acquérir une valeur de puissance aller L1 dans le domaine numérique d'un canal de transmission aller ;
une deuxième unité d'acquisition (220), adaptée pour acquérir une valeur de gain L2 d'un circuit de gain variable du canal de transmission aller ;
une troisième unité d'acquisition (230), adaptée pour acquérir une valeur de puissance retour L3 d'un signal de puissance retour échantillonné, le signal de puissance retour échantillonné étant échantillonné à partir de signaux de puissance retour par un coupleur retour (231) ; et
une unité de calcul d'ondes stationnaires (240), adaptée pour obtenir un rapport d'ondes stationnaires en fonction de L1, L2 et L3, le rapport d'ondes stationnaires étant obtenu en fonction de L3 et d'une valeur de puissance aller L4 obtenue en fonction de L1 et de L2, dans lequel les L1, L2 et L3 sont acquises dans une même tranche de temps.

6. Dispositif de détection d'ondes stationnaires selon la revendication 5, comprenant en outre :
une unité de détermination (250) adaptée pour déterminer si les L1, L2 et L3 sont valables ou non ; et
une unité de déclenchement (260) adaptée pour déclencher l'unité de calcul d'ondes stationnaires (240) afin d'obtenir le rapport d'ondes stationnaires en fonction des L1,
L2 et L3 si l'unité de détermination détermine que les L1, L2 et L3 sont toutes valables.

7. Dispositif de détection d'ondes stationnaires selon la revendication 5 ou 6, dans lequel la troisième unité d'acquisition comprend :
ledit coupleur retour (231), couplé au niveau d'une extrémité d'entrée à une extrémité de sortie retour d'un duplexeur et au niveau d'une extrémité de sortie à une extrémité d'entrée d'un module de traitement de rétroaction (150), et adapté pour échantillonner des signaux de puissance retour et produire en sortie un signal de puissance retour échantillonné ;
le module de traitement de rétroaction (150), adapté pour convertir le signal de puissance retour échantillonné produit en sortie par le coupleur retour (231) en un signal de puissance retour échantillonné dans un domaine numérique et produire en sortie le signal de puissance retour échantillonné dans le domaine numérique ; et
un module de détection (232), adapté pour détecter la valeur de puissance retour L3 du signal de puissance retour échantillonné dans le domaine numérique produit en sortie par le module de traitement de rétroaction (150).

8. Dispositif de détection d'ondes stationnaires selon la revendication 7, dans lequel le module de traitement de rétroaction comprend :
un mélangeur (151), adapté pour exécuter un traitement de conversion de fréquence sur le signal de puissance retour échantillonné produit en sortie par le coupleur retour (231), et produire en sortie le signal traité ; et
un convertisseur analogique/numérique (A/N) (152), adapté pour convertir le signal de puissance retour échantillonné converti en fréquence et produit en sortie par le mélangeur (151) en le signal de puissance retour échantillonné dans le domaine numérique.

9. Dispositif de détection d'ondes stationnaires selon l'une quelconque des revendications 5 à 8, dans lequel l'unité de calcul d'ondes stationnaires (240) obtient le rapport d'ondes stationnaires en fonction de valeurs moyennes de multiples L1, L2 et L3.

10. Station de base, comprenant un dispositif de détection d'ondes stationnaires selon l'une quelconque des revendications 5 à 9.

11. Station de base selon la revendication 10, comprenant en outre :
une unité de commutation (270), adaptée pour commuter un signal d'entrée du module de traitement de rétroaction (150) entre le signal de puissance aller échantillonné et le signal de puissance retour échantillonné ;
une unité de commande de commutation (280), adaptée pour commander l'opération de commutation de l'unité de commutation (270).

12. Station de base selon la revendication 11, comprenant en outre :
un coupleur aller (140), adapté pour échantillonner des signaux de puissance aller et produire en sortie un signal de puissance aller échantillonné, le coupleur aller (140) ayant une extrémité d'entrée couplée à une extrémité de sortie aller du duplexeur (130) et une extrémité de sortie couplée à l'extrémité d'entrée du module de traitement de rétroaction (150), et le module de traitement de rétroaction (150) est adapté en outre pour convertir le signal de puissance aller échantillonné produit en sortie par le coupleur aller (140) en un signal de puissance aller échantillonné dans le domaine numérique et produire en sortie le signal de puissance aller échantillonné dans le domaine numérique ; et
une unité de traitement de commande de puissance à boucle fermée (160), adaptée pour régler une valeur de gain du circuit de gain variable du canal de transmission aller en fonction du signal de puissance aller échantillonné d'entrée dans le domaine numérique après que l'unité de commutation commute le signal d'entrée du module de traitement de rétroaction (150) sur le signal de puissance aller échantillonné.

13. Station de base selon la revendication 11 ou 12, dans laquelle :
le mélangeur (151) est adapté en outre pour exécuter un traitement de conversion de fréquence sur le signal de puissance aller échantillonné produit en sortie par le coupleur retour (231), et
le convertisseur A/N (152) est adapté en outre pour convertir le signal de puissance aller échantillonné converti en fréquence et produit en sortie par le mélangeur en le signal de puissance aller échantillonné dans le domaine numérique.
